# EUROPÄISCHE PATENTSCHRIFT

(11) **EP 4 386 304 B1**
(45) Veröffentlichungstag und Bekanntmachung des Hinweises auf die Patenterteilung: **01.07.2026**
(21) Anmeldenummer: 24174016.6
(22) Anmeldetag: 05.07.2023
(51) Int. Cl.: F28F 9/02, F28F 9/26, F28F 21/06, F28F 21/08, H01M 10/613, H01M 10/625, H01M 10/653, H01M 10/6556, H01M 10/6567

(54) **KÜHLBAUTEIL**
COOLING COMPONENT
COMPOSANT DE REFROIDISSEMENT

(30) Priorität: 18.07.2022 DE 102022117863; 09.06.2023 DE 102023115116
(43) Veröffentlichungstag der Anmeldung: 19.06.2024
(62) Teilanmeldung aus: 23183576.0
(73) Patentinhaber: Erwin Quarder Systemtechnik GmbH, 32339 Espelkamp (DE)
(72) Erfinder: Heitbrink, Alexander, 32351 Stemwede (DE); Siewert, Georg, 35415 Pohlheim (DE)
(74) Vertreter: Geskes, Christoph

(56) Entgegenhaltungen:
- EP-A1- 3 885 689
- DE-A1- 102016 125 859
- US-A1- 2014 090 812
- US-A1- 2017 343 144

## Beschreibung

Die vorliegende Erfindung betrifft ein Kühlbauteil mit einem insbesondere länglichen, vorzugsweise beschichteten Kühlkörper aus Metall oder aus einer Metalllegierung, insbesondere Aluminium, mit dem ein Gegenstand gekühlt werden kann, wobei der Kühlkörper über ein oder mehrere, vorzugsweise parallele, insbesondere längliche und/oder geradlinige Mediumkanäle zum Durchfluss von Kühlmedium verfügt, und mit einem mit dem Kühlkörper fluiddicht verbundenen Anschlussteil, über das dem Kühlkörper das Kühlmedium zuführbar ist und/oder über das von dem Kühlkörper das Kühlmedium abführbar ist.

Kühlbauteile zum Abführen von Wärme von zu kühlenden Gegenständen werden auch als Wärmetauscher bezeichnet und in vielen Bereichen der Technik eingesetzt. Besondere Bedeutung kommt solchen Kühlbauteilen unter anderem bei der Kühlung von Batterie- bzw. Akkumulatorensystemen für Elektrofahrzeuge zu, aber auch von Leistungselektronikbauteilen, von Busbars oder von Prozessorchips. Die eingangs genannten Kühlbauteile sind dabei in der Regel Bestandteil einer übergeordneten Kühleinrichtung, die dafür sorgt, dass Kühlmedium, wie etwa Wasser oder dergleichen, kontinuierlich durch das Kühlbauteil geführt wird.

Die Kühlkörper, die im Betrieb in der Regel an dem zu kühlenden Gegenstand anliegen, zumindest aber in der unmittelbaren Nähe desselben angeordnet sind, sind häufig aus einzelnen Bauteilen aus Metall oder einer Metalllegierung (bspw. Stahl) hergestellt, indem diese aufwändig miteinander verschweißt oder verlötet sind. Das mit dem Kühlkörper verbundene Anschlussteil zum Zu- und/oder Abführen von Kühlmedium besteht dabei häufig aus demselben Metall bzw. aus derselben Metalllegierung wie der Kühlkörper und ist mit diesem ebenfalls aufwändig verschweißt oder verlötet. Da solche Anschlussteile in der Regel allerdings nicht für die unmittelbare Wärmeübertragung von dem zu kühlenden Gegenstand auf das Kühlbauteil gedacht sind, wäre es eigentlich nicht erforderlich, auch die Anschlussteile aus hochwärmeleitendem, metallischem Material herzustellen. Dies ist funktional sogar eher kontraproduktiv. DE 10 2016 125859 A1 offenbart eine flexible Anbindung eines metallischen Strangpressprofils an einen Anschlusskörper zur Verwendung in Kühlanwendungen für elektrische Komponenten und offenbart einen Kühlbauteil gemäß dem Oberbegriff des Anspruchs 1. US 2014/090812 A1 offenbart einen Wärmetauscher mit einem ersten Sammelkasten und mit einem zweiten Sammelkasten, mit mindestens einem zwischen den beiden Sammelkästen angeordneten Rohr, wobei ein Fluideinlass und ein Fluidauslass vorgesehen sind, die einzeln an jeweils einem der Sammelkästen oder an einem einzigen der Sammelkästen angeordnet sind.

Es ist Aufgabe der vorliegenden Erfindung, das eingangs genannte Kühlbauteil weiterzuentwickeln.

Diese Aufgabe wird gelöst durch ein Kühlbauteil mit den Merkmalen des Anspruchs 1.

Ein erfindungsgemäßes Kühlbauteil ist demnach dadurch gekennzeichnet, dass zur Verbindung des Anschlussteils mit dem vorzugsweise aus Aluminium hergestellten bzw. bestehenden Kühlkörper ein erster, insbesondere endständiger Verbindungsbereich des Kühlkörpers in den Aufnahmeraum einer Aufnahme des Anschlussteils eingebracht ist und dort mit der Aufnahme fluiddicht verbunden ist, der mehrere Verbindungsflächen aufweist mit jeweils durch physikalische und/oder chemische Nano- oder Mikrostrukturierungsverfahren eingebrachten, dreidimensionalen Nano- und/oder Mikrostrukturen. Dabei ist der Verbindungsbereich des Kühlkörpers mit der Aufnahme fluiddicht verbunden, indem jede Verbindungsfläche des Kühlkörpers jeweils einer zugeordneten Verbindungsfläche der Aufnahme gegenüberliegt und mit dieser (unter thermischer Direktfügung) verpresst ist.

Ein Verfahren zur Herstellung eines solchen Kühlbauteils umfasst folgende Maßnahmen:
a) Einführen eines bzw. des insbesondere endständigen Verbindungsbereichs eines/des vorgefertigten, insbesondere durch Profilextrusion hergestellten, insbesondere einstückig gefertigten oder einstückig ausgebildeten Kühlkörpers in den Aufnahmeraum einer Aufnahme eines/des vorgefertigten, insbesondere spritzgegossenen Anschlussteils aus Kunststoff für den Kühlkörper mittels Relativbewegung zwischen Kühlkörper und Anschlussteil, sodass jede von mehreren, sich jeweils insbesondere parallel gegenüberliegenden Verbindungsflächen des Verbindungsbereichs des Kühlkörpers mit jeweils durch physikalische und/oder chemische Nano- oder Mikrostrukturierungsverfahren eingebrachten, dreidimensionalen Nano- und/oder Mikrostrukturen, jeweils einer zugeordneten Verbindungsfläche der Aufnahme des Anschlussteils gegenüberliegt, insbesondere einer jeweils zugeordneten Verbindungsfläche, die an einer Innenseite einer Wandung der Aufnahme angeordnet ist,
b) Erwärmen der Verbindungsflächen des Kühlkörpers, insbesondere mittels Induktion, auf eine Temperatur, die mindestens der Schmelztemperatur des Kunststoffs des Anschlussteils entspricht, insbesondere bevor der Verbindungsbereich des Kühlkörpers in den Aufnahmeraum der Aufnahme eingeführt wird und/oder während sich der Verbindungsbereich in dem Aufnahmeraum befindet,
c) fluiddichtes Verbinden von allen erwärmten Verbindungsflächen des Kühlkörpers mit der jeweils gegenüberliegenden Verbindungsfläche des Anschlussteils durch Verpressen dieser sich gegenüberliegenden Verbindungsflächen unter Aufschmelzen der Verbindungsfläche des Anschlussteils durch die Wärme der Verbindungsfläche des Kühlkörpers.

Die Verwendung eines Anschlussteils aus Kunststoff ist zum einen deutlich kostengünstiger als die Verwendung eines Anschlussteils aus Metall bzw. Metalllegierungen und zum anderen kann die vergleichsweise geringe Wärmeleitfähigkeit von Kunststoff in diesem Zusammenhang funktional vorteilhaft sein, um beispielsweise einen ungewollten Wärmeübertrag auf das Kühlmedium im Bereich des Anschlussteils zu verhindern.

Da das Kunststoffteil erfindungsgemäß eine Aufnahme mit Aufnahmeraum für den Kühlkörper aufweist bzw. für einen Verbindungsbereich desselben, kann durch die thermische Direktfügung unter Verwendung der Nano- und Mikrostrukturen im Rahmen eines vorteilhaften, insbesondere positionsgenauen Herstellungsprozesses eine stabile und fluiddichte Verbindung zwischen dem metallischen Kühlkörper - unter "metallisch" werden im Rahmen der Anmeldung der Einfachheit halber sowohl Metalle als auch Metalllegierungen gefasst - und dem Anschlussteil aus Kunststoff geschaffen werden. Vorteilhafterweise kann der Kühlkörper ein länglicher, insbesondere extrudierter, bevorzugt quaderförmiger, vorzugsweise einstückiger bzw. einstückig hergestellter Profilkörper mit mehreren, die Außenseiten bzw. Außenwandungen desselben bildenden Profilkörperwandungen sein. Er kann dabei beispielsweise ein sogenannter Pocketprofilkörper sein.

Was diese äußeren Kühlköperwandungen betrifft, so kann eine großflächige erste Wandung vorgesehen sein und eine von dieser beabstandete, zu der ersten großflächigen Wandung insbesondere parallel verlaufende großflächige zweite Wandung. Zudem können zwei voneinander beabstandete, die erste großflächige Wandung und die zweite großflächige Wandungjeweils miteinander verbindende Schmalseitenwandungen vorgesehen sein.

Eine, mehrere oder sämtliche dieser Kühlkörperaußenwandungen können eben (bzw. ungekrümmt), gebogen (bzw. gekrümmt) oder gewellt ausgebildet sein.

Die Verwendung von ein oder mehreren solcher gekrümmten oder gewellten Kühlkörperaußenwandungen kann dabei beispielsweise die Anlage an zu kühlende Gegenstände verbessern oder erst ermöglichen, die ebenfalls über gekrümmte Außenwandungen verfügen, wie beispielsweise die Anlage an sogenannte Batterie- bzw. Akku-Rundzellen.

Der Kühlkörper aus Metall, insbesondere eine, mehrere oder jede Kühlkörperaußenwandung desselben, kann des Weiteren ganz oder teilweise auf einer, mehreren oder sämtlichen Außenseiten beschichtet sein, insbesondere (ggf. jeweils) mit einer elektrisch isolierenden Isolierschicht. Dies, um beispielsweise Kurzschlüsse zu verhindern, wenn der Kühlkörper an einen zu kühlenden Gegenstand angelegt wird, der nicht elektrisch isoliert ist. Diese bzw. die jeweilige elektrisch isolierende Isolierschicht kann beispielsweise eine (geeignete) Lackschicht sein, eine Folienschicht, eine PowderCoating-Schicht oder dergleichen.

Was die Verbindungsflächen des Kühlkörpers betrifft, so können diese dabei (endständige) Bereiche der Außenseiten dieser Profikörperwandungen bilden bzw. in (endständigen) Bereichen dieser Außenseiten angeordnet sein.

Zweckmäßigerweise weist die Aufnahme des Anschlussteils im Übrigen Aufnahmewandungen auf, die den Aufnahmeraum begrenzen und an deren Innenseiten die Verbindungsflächen des Anschlussteils bzw. der Aufnahme angeordnet sind bzw. deren Innenseiten die Verbindungsflächen der Aufnahme bilden.

In weiterer Ausbildung der Erfindung kann das Anschlussteil eine Zulaufkammer mit Zulauföffnung zur Zuführung von Kühlmedium zu dem Kühlbauteil aufweisen.

Vorzugsweise kann weiter vorgesehen sein, dass in der Zulaufkammer Öffnungen oder offene Enden bzw. offene Seiten (insbesondere offene Querseiten) der Mediumkanäle einer ersten Gruppe von Mediumkanälen münden oder angeordnet sind, über die dieser ersten Gruppe von Mediumkanälen Kühlmedium, das dem Kühlbauteil über die Zulauföffnung und die Zulaufkammer zuführbar ist, zugeleitet werden kann.

In weiterer Ausbildung der Erfindung kann das Anschlussteil des Weiteren eine insbesondere von der Zulaufkammer getrennte Ablaufkammer mit Ablauföffnung zur Abführung von Kühlmedium aus dem Kühlbauteil aufweisen.

Dabei kann vorgesehen sein, dass in der Ablaufkammer Öffnungen oder offene Enden bzw. Seiten einer (anderen) zweiten Gruppe von Mediumkanälen münden oder angeordnet sind, über die Kühlmedium aus den Mediumkanälen dieser, insbesondere von der ersten Gruppe getrennten zweiten Gruppe von Mediumkanälen in die Ablaufkammer fließen kann, das von dort über die Ablauföffnung aus dem Kühlbauteil abführbar ist.

Weiter kann vorgesehen sein, dass der erste Verbindungsbereich an dem einen Ende des Kühlkörpers angeordnet ist, und dass an einem oder dem zweiten, anderen Ende des Kühlkörpers ein zweiter Verbindungsbereich des Kühlkörpers mit mehreren Verbindungsflächen angeordnet ist mit jeweils durch physikalische und/oder chemische Nano- oder Mikrostrukturierungsverfahren eingebrachten, dreidimensionalen Nano- und/oder Mikrostrukturen, der in den Aufnahmeraum einer Aufnahme einer Umlenkkappe eingebracht ist oder in den Aufnahmeraum einer Aufnahme eines weiteren Anschlussteils aus Kunststoff, über das dem Kühlkörper das Kühlmedium zuführbar ist und/oder über das von dem Kühlkörper das Kühlmedium abführbar ist, und dort mit der Aufnahme der Umlenkkappe bzw. der Aufnahme des weiteren Anschlussteils fluiddicht verbunden ist, indem jede Verbindungsfläche des Kühlkörpers jeweils einer zugeordneten Verbindungsfläche der Aufnahme gegenüberliegt und mit dieser (unter thermischer Direktfügung) verpresst ist.

Das weitere Anschlussteil kann dabei funktional genauso oder ähnlich ausgebildet sein wie das zuvor beschriebene (erste) Anschlussteil. So ist vorstellbar, dass beispielsweise an einem Ende des Kühlkörpers das (erste) Anschlussteil angeordnet ist und über dieses dem Kühlbauteil Kühlmedium zugeführt wird, und am anderen Ende das weitere bzw. zweite Anschlussteil, über das das Kühlmedium dann aus dem Kühlbauteil abgeführt wird. Hier sind diverse Ausführungsformen denkbar.

Weiter ist aber auch denkbar, dass das Kühlbauteil ein Anschlussteil aufweist, das über zwei oder mehr Aufnahmeräumen verfügt, wobei das Kühlbauteil dann entsprechend auch mehrere Kühlkörper (für jeden Aufnahmeraum einen) aufweist, wie sie in der vorliegenden Anmeldung beschrieben sind, und deren eines Ende dann jeweils den ersten Verbindungsbereich aufweist, der dann mit einem zugeordneten Aufnahmeraum in der in der Anmeldung beschriebenen Weise fluiddicht verbunden ist. Das jeweils andere, zweite Ende des jeweiligen Kühlkörpers kann dann jeweils den zweiten Verbindungsbereich aufweisen, der dann jeweils in der beschriebenen Weise mit einer solchen Umlenkkappe und/oder mit jeweils einem solchen weiteren Anschlussteil verbunden ist.

Dabei können die Mediumkanäle der ersten Gruppe und der zweiten Gruppe von Mediumkanälen auch im Bereich des anderen Endes des Kühlkörpers offene Seiten bzw. Enden oder Öffnungen aufweisen, wobei diese offenen Seiten/Enden bzw. Öffnungen in einem Umlenkraum der Umlenkkappe angeordnet sind bzw. in diesen münden. Dabei ist die Umlenkkappe derart ausgebildet, dass Kühlmedium, das aus den in dort angeordneten offenen Seiten/Enden oder Öffnungen der Mediumkanäle der ersten Gruppe von Mediumkanälen in den Umlenkraum strömt oder strömen kann, in dem Umlenkraum zu den offenen Seiten/Enden oder Öffnungen der Mediumkanäle der zweiten Gruppe von Mediumkanälen umgelenkt wird und in diese eintreten kann, danach durch die Mediumkanäle der zweite Gruppe von Mediumkanälen fließt und weiter über die in der Ablaufkammer angeordneten offenen Seiten/Enden bzw. Öffnungen dieser Mediumkanäle in die Ablaufkammer strömt.

Die bzw. sämtliche Mediumkanäle können im Übrigen länglich und geradlinig ausgebildet sein und in dem Kühlkörper nebeneinander angeordnet parallel zur Haupterstreckungsrichtung des Kühlkörpers verlaufen.

Vorzugsweise kann jeder (längliche) Mediumkanal an zwei (gegenüberliegenden) Querseiten oder Enden offen sein.

Jeder (längliche) Mediumkanal kann des Weiteren an (allen) seinen Längsseiten (bezogen auf die Haupterstreckungsrichtung des Mediumkanals) durch Mediumkanalwandungen begrenzt sein. Dies insbesondere durch ein oder zwei Paare von sich jeweils mit Abstand gegenüberliegenden Mediumkanalwandungen, wobei die Mediumkanalwandungen eines der Paare oder des Paares jeweils durch die erste bzw. die zweite großflächige Wandung des Kühlbauteils gebildet wird.

Zusätzlich oder alternativ kann jeder (längliche) Mediumkanal des Weiteren an seinen Querseiten (bezogen auf die Haupterstreckungsrichtung des Mediumkanals) offen sein, wobei vorzugsweise die offenen Querseiten diejenigen offenen Seiten bilden, die in der Ablaufkammer bzw. der Zulaufkammer bzw. dem Umlenkraum angeordnet sind.

Weiter vorzugsweise verlaufen die Mediumkanalwandungen eines der Paare oder des Paares, insbesondere des anderen Paares, parallel zueinander und/oder senkrecht zu der ersten bzw. zweiten großflächigen Wandung.

Weiter vorzugsweise teilen sich jeweils benachbarte Mediumkanäle (seitlich) an einer Längsseite eine gemeinsame Mediumkanalwandung des Kühlkörpers.

Bei den beiden äußeren Mediumkanälen der (in einer Reihe) nebeneinander angeordneten Mediumkanälen kann im Übrigen eine der Mediumkanalwandungen durch eine der Schmalseitenwände des Kühlkörpers gebildet sein.

Weiter vorzugsweise verlaufen die Mediumkanäle jeweils insbesondere geradlinig zwischen dem mit dem einen endständigen Verbindungsbereich verbundenen Anschlussteil einerseits und der mit dem anderen endständigen Verbindungsbereich verbundenen Umlenkkappe andererseits.

Mit der oben beschrieben Ausgestaltung kann beispielsweise Kühlmedium über das Anschlussteil, insbesondere über die Zulauföffnung bzw. die Zulaufkammer, den Mediumkanälen der ersten Gruppe von Mediumkanälen über deren in der Zulaufkammer angeordneten offenen Seiten/Enden bzw. Öffnungen zugeleitet werden, das dann diese Mediumkanäle durchströmt, aus den anderen offenen Seiten/Enden bzw. Öffnungen dieser ersten Gruppe am anderen Ende des Kühlkörpers, die in dem Umlenkraum angeordnet sind, herausfließt und in die Umlenkkappe strömt, dann über die dort angeordneten offenen Seiten/Enden bzw. Öffnungen der zweiten Gruppe von Mediumkanälen in die Mediumkanäle dieser zweiten Gruppe umgelenkt wird, dann in diesen zum Anschlussteil (zurück)fließt, dann aus deren in der Ablaufkammer angeordneten offenen Seiten/Enden bzw. Öffnungen in die Ablaufkammer hineinströmt und schließlich aus dem Anschlussteil abgeführt wird. Auf dem beschriebenen Weg innerhalb des Kühlkörpers kann das Kühlmedium dabei die Abwärme eines/des zu kühlenden Gegenstands (über seine Außenwandungen bzw. Außenseiten) aufnehmen und diese ableiten.

Die Hauptströmungsrichtung des Kühlmediums kann im Übrigen innerhalb der Zulaufkammer winklig, vorzugsweise quer zu den Mediumkanälen bzw. zu der Haupterstreckungsrichtung der Mediumkanäle oder zu der Hauptströmungsrichtung in den Mediumkanälen verlaufen. In die Zulaufkammer kann dann dabei, insbesondere zur Optimierung der Strömung des Kühlmittels von der Zulauföffnung zu den Mediumkanälen, eine bevorzugt einstückig mit dem Anschlussteil, insbesondere der Aufnahme des Anschlussteils verbundene, mindestens bereichsweise winklig zur Hauptströmungsrichtung in der Zulaufkammer verlaufende (und insbesondere mindestens bereichsweise in Richtung der Zulauföffnung gekrümmte) Fluidleitwandung hineinragen, die das an ihr entlang strömende bzw. auf sie treffende Kühlmedium geeignet in Richtung der Mediumkanäle leitet/führt.

Alternativ oder zusätzlich kann die Hauptströmungsrichtung des Kühlmediums innerhalb der Ablaufkammer (ggf. jeweils) winklig, vorzugsweise quer zu den Mediumkanälen bzw. zu der Haupterstreckungsrichtung derselben oder zu der Hauptströmungsrichtung innerhalb derselben verlaufen, wobei (ggf. auch) in die Ablaufkammer eine insbesondere einstückig mit dem Anschlussteil, insbesondere der Aufnahme des Anschlussteils verbundene, mindestens bereichsweise winklig zur Hauptströmungsrichtung in der Ablaufkammer verlaufende (und insbesondere mindestens bereichsweise in Richtung der Ablauföffnung gekrümmte) Fluidleitwandung hineinragt. Dies ebenfalls insbesondere zur Optimierung der Strömung des Kühlmittels, allerdings aus den Mediumkanälen heraus hin zu der Ablauföffnung.

Bevorzugt kann sich die Zulauföffnung an einem Ende der Zulaufkammer befinden und an einem anderen Ende eine Anschlussöffnung, an die ein Anschlussteil eines identischen oder gleichartigen weiteren Kühlbauteils anschließbar ist, insbesondere zur Verbindung der Zulauföffnung des weiteren Kühlbauteils mit der Anschlussöffnung.

Zusätzlich oder alternativ kann vorgesehen sein, dass sich die Ablauföffnung an einem Ende der Ablaufkammer befindet und an einem anderen Ende eine Anschlussöffnung, an die ein Anschlussteil eines identischen oder gleichartigen weiteren Kühlbauteils anschließbar ist, insbesondere zur Verbindung der Ablauföffnung des weiteren Kühlbauteils mit der Anschlussöffnung.

Die Zulauföffnung und/oder die Anschlussöffnung können sich im Übrigen in einer Ebene erstrecken, die sich winklig, vorzugsweise quer zur Hauptströmungsrichtung innerhalb der Zulaufkammer bzw. zur Haupterstreckungsrichtung der Zulaufkammer erstreckt. Zusätzlich und/oder alternativ können sich die Ablauföffnung und/oder die Anschlussöffnung in einer Ebene erstrecken, die sich winklig, vorzugsweise quer zur Hauptströmungsrichtung innerhalb der Ablaufkammer bzw. zur Haupterstreckungsrichtung der Ablaufkammer erstreckt.

In weiterer Ausbildung der Erfindung kann vorgesehen sein, dass das Kühlbauteil Verbindungsmittel, insbesondere Rastmittel aufweist zur lösbaren Verbindung des Kühlbauteils mit einem identischen weiteren Kühlbauteil.

Dies insbesondere derart, dass nach einer solchen Verbindung die Anschlussöffnung der Zulaufkammer des Kühlbauteils mit der Zulauföffnung der Zulaufkammer des weiteren Kühlbauteils unter fluidleitender Verbindung zwischen diesen Öffnungen fluchtet und/oder derart, dass nach einer solchen Verbindung die Anschlussöffnung der Ablaufkammer des Kühlbauteils mit der Ablauföffnung der Ablaufkammer des weiteren Kühlbauteils unter fluidleitender Verbindung zwischen diesen Öffnungen fluchtet.

Was das Herstellverfahren betrifft, so kann des Weiteren vorgesehen sein, dass alle Verbindungsflächen des Kühlkörpers oder nur ein Paar von bzw. der sich insbesondere mit Abstand zueinander gegenüberliegenden Verbindungsflächen des Kühlkörpers mit der jeweils gegenüberliegenden Verbindungsfläche des Anschlussteils verpresst werden/wird, indem ein Pressorgan jeweils die jeweilige Verbindungsfläche des Anschlussteils gegen die ihr jeweils gegenüberliegende Verbindungsfläche des Kühlkörpers drückt.

Weiter kann allgemein vorgesehen sein, dass alle Verbindungsflächen des Kühlkörpers oder nur ein Paar von sich insbesondere gegenüberliegenden Verbindungsflächen des Kühlkörpers mit der jeweils gegenüberliegenden Verbindungsfläche des Anschlussteils verpresst werden/wird, indem der Abstand gegenüberliegender Verbindungsflächen des Kühlkörpers zueinander auf den Abstand gegenüberliegender Verbindungsflächen des Anschlussteils zueinander abgestimmt ist oder wird, sodass durch das Erwärmen dieser Verbindungsflächen des Kühlkörpers in dem in den Aufnahmeraum des Anschlussteils eingeführten Zustand des Verbindungsbereichs des Kühlkörpers aufgrund thermischer Ausdehnung des Kühlkörpermaterials eine Presspassung entsteht, in deren Zuge die jeweilige Verbindungsfläche des Kühlkörpers gegen die jeweils gegenüberliegende Verbindungsfläche des Anschlussteils gedrückt wird.

Weiter kann vorgesehen sein, dass durch ein jeweiliges Pressorgan diejenigen Verbindungsflächen des Anschlussteils gegen die jeweils gegenüberliegende Verbindungsfläche des Kühlkörpers gedrückt werden, die jeweils der ersten großflächigen Wandung bzw. der zweiten großflächigen Wandung des Kühlkörpers gegenüberliegen, und/oder dass diejenigen Verbindungsflächen des Anschlussteils, die jeweils einer Verbindungsfläche einer der Schmalseitenwände des Kühlkörpers gegenüberliegen, durch die Presspassung mit derjeweiligen Verbindungsfläche des Kühlkörpers verbunden werden.

Weiter kann vorgesehen sein, dass die Verbindungsflächen sämtlicher dieser Wandungen des Kühlkörpers mit der jeweils gegenüberliegenden Verbindungsfläche des Anschlussteils durch ein jeweiliges, die Verbindungfläche des Anschlussteils gegen die jeweilige Wandung drückendes Pressorgan verbunden werden.

Weiter kann vorgesehen sein, dass das Drücken der jeweiligen Verbindungsfläche des Anschlussteils gegen die jeweils gegenüberliegende Verbindungsfläche des Kühlkörpers mittels des jeweiligen Pressorgans erfolgt, indem dieses Druck auf diejenige Wandung der Aufnahme ausübt, an der die jeweilige Verbindungsfläche angeordnet ist, insbesondere auf die Außenseite dieser Wandung.

Weitere Merkmale der vorliegenden Erfindung ergeben sich aus den beigefügten Patentansprüchen, der nachfolgenden Beschreibung bevorzugter Ausführungsbeispiele sowie aus den beigefügten Zeichnungen.

Darin zeigt:

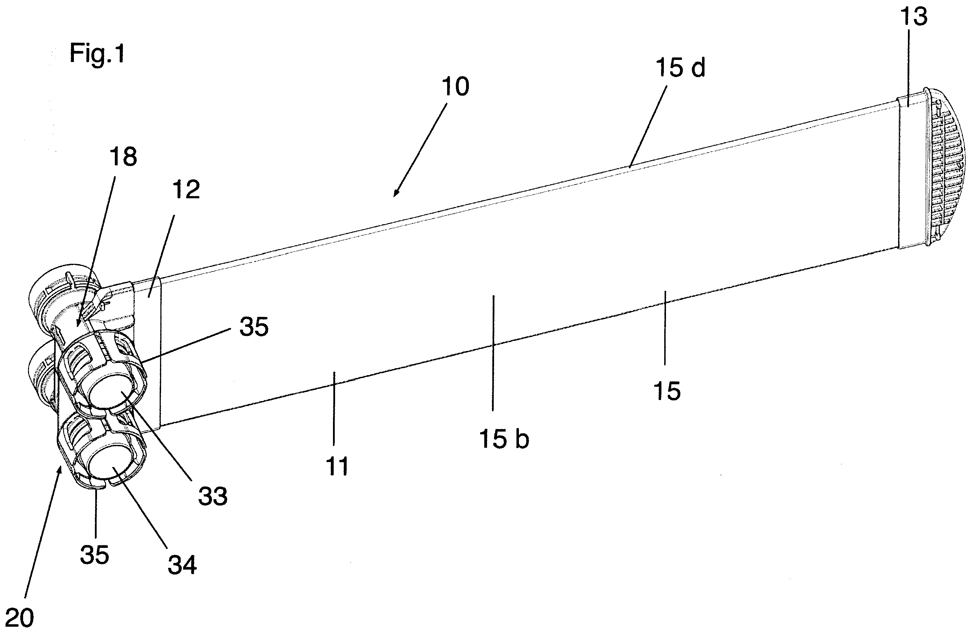

- Fig. 1: eine Ausführungsform eines erfindungsgemäßen Kühlbauteils mit Kühlkörper, Anschlussteil (an einem Ende des Kühlkörpers) und Umlenkkappe (am anderen Ende des Kühlkörpers), in Schrägansicht von unten,

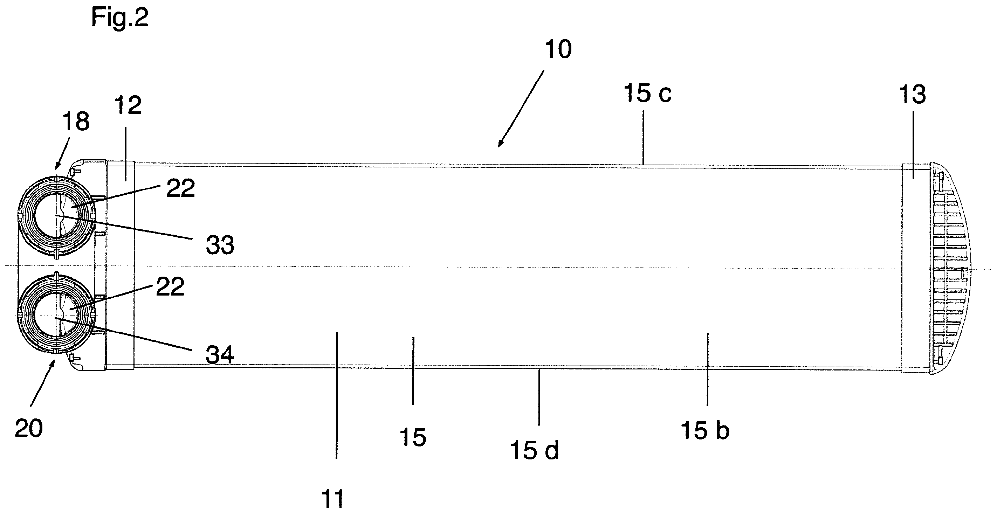

- Fig. 2: eine Unteransicht des Kühlbauteils aus Fig. 1,

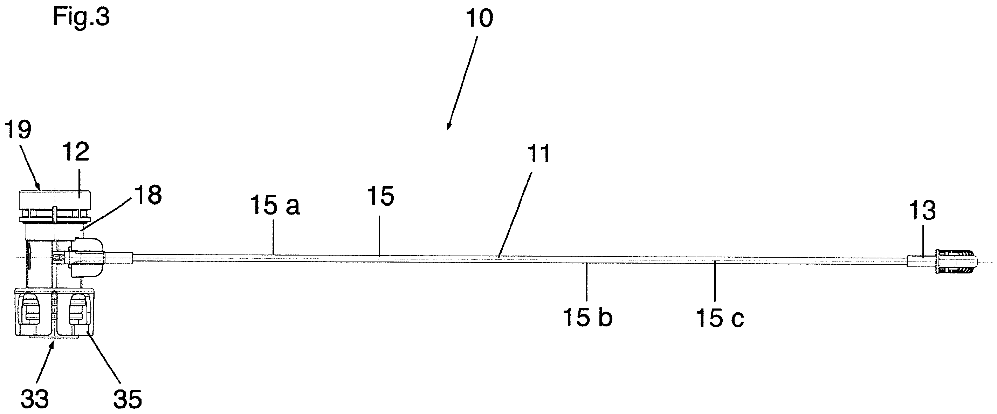

- Fig. 3: eine Seitenansicht des Kühlbauteils aus Fig. 1,

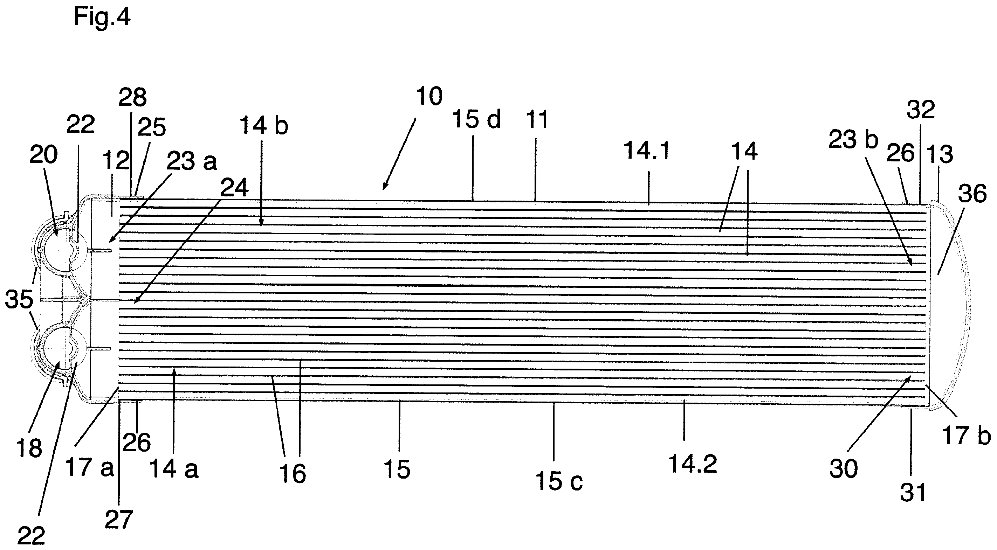

- Fig. 4: einen Längsschnitt (horizontal) durch das Kühlbauteil aus Fig. 1,
- Fig. 5: einen Schnitt durch das Anschlussteil des Kühlbauteils aus Fig. 1,

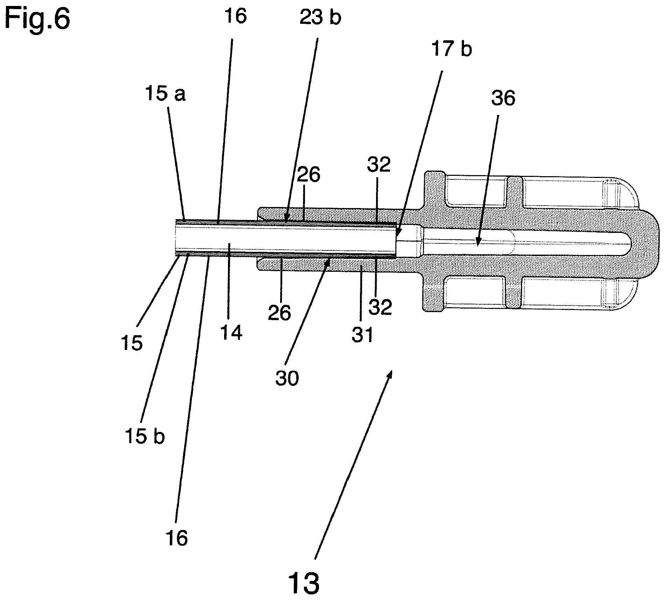

- Fig. 6: einen Schnitt durch die Umlenkkappe aus Fig. 1.

In den Zeichnungen ist ein Kühlbauteil 10 gezeigt, wie es beispielsweise im Rahmen der Kühlung von Batterie- bzw. von Akkumulatorensystemen von Elektrofahrzeugen verwendet wird, um die jeweiligen Batterien bzw. die einzelnen Zellen zu kühlen.

Ein solches Kühlbauteil 10 ist dabei in der Regel Bestandteil einer übergeordneten Kühleinrichtung, die dafür sorgt, dass kontinuierlich Kühlmedium durch das Kühlbauteil 10 geführt wird, das dabei Abwärme des zu kühlenden Gegenstands aufnimmt und diese dann abführt. Die hierfür notwendigen Bauteile der Kühleinrichtung, etwa eine geeignete Pumpe, Zu- und Ablaufleitungen für das Kühlmedium etc., sind im Stand der Technik bekannt und werden daher nicht näher erläutert.

Im vorliegenden Fall kann das Kühlbauteil 10 im Einsatz mit (nicht gezeigten) identischen weiteren Kühlbauteilen der Kühleinrichtung verbunden werden, die dann zur gleichen Zeit mehrere zu kühlende Gegenstände kühlen können, beispielsweise mehrere Batterien bzw. Batteriezellen.

Das Kühlbauteil 10 verfügt über einen Kühlkörper 11 aus Metall, vorliegend aus Aluminium, der im Einsatz an dem zu kühlenden Gegenstand anliegt oder zumindest unmittelbar benachbart zu diesem angeordnet wird.

Der Kühlkörper 11 ist länglich ausgebildet, vorliegend im Wesentlichen als (sehr) flacher Quader.

Bezogen auf die Haupterstreckungsrichtung des Kühlbauteils 10 bzw. des Kühlkörpers 11 ist an einem Ende desselben ein Anschlussteil 12 angeordnet, über das dem Kühlbauteil 10 Kühlmedium, wie etwa Kühlwasser oder dergleichen, zugeführt werden kann, das innerhalb einer ersten Gruppe 14 a von länglichen Mediumkanälen 14 dann in der Haupterstreckungsrichtung des Kühlkörpers 11 bzw. in Längsrichtung zu dem anderen Ende des Kühlkörpers 11 geführt wird, dann in einer an dem anderen Ende des Kühlbauteils 10 bzw. des Kühlkörpers 11 angeordneten Umlenkkappe 13 umgelenkt wird und in entgegengesetzter Richtung durch eine zweite Gruppe 14 b von länglichen Mediumkanäle in entgegengesetzter Richtung durch den Kühlkörper 10 strömt, bis es wieder das Anschlussteil 12 erreicht und über das Anschlussteil 12 aus dem Kühlbauteil 10 herausgeführt oder abgeführt wird.

Auf seinem Weg durch den Kühlkörper 11 bzw. die Mediumkanäle 14 nimmt das Kühlmedium im Betrieb der Kühleinrichtung bzw. des Kühlbauteils 10 die Abwärme des zu kühlenden Gegenstands unter Kühlung des zu kühlenden Gegenstandes auf und transportiert diese ab.

Der Kühlkörper 11 ist vorliegend einstückig gefertigt. Dabei kann es sich um einen Profilkörper bzw. ein Profilstück (Pocketprofil) handeln, das im (Aluminium-) Extrusionsverfahren hergestellt wurde.

Der Kühlkörper 11 verfügt vorliegend über vier Kühlkörperaußenwandungen 15, nämlich eine erste großflächige, obere Wandung 15 a, eine zweite großflächige, der oberen Wandung parallel mit Abstand gegenüberliegende, untere Wandung 15 b, sowie zwei parallel zueinander verlaufende, die obere Wandung 15 a und die untere Wandung 15 b jeweils miteinander verbindende Schmalseitenwandungen 15 c bzw. 15 d.

Die (länglichen) Mediumkanäle 14 sind im Inneren des Kühlkörpers 11 angeordnet, also im Inneren des durch die Körperaußenwandungen 15 eingeschlossenen Raums. Die Mediumkanäle 14 erstrecken sich dabei parallel zur Haupterstreckungsrichtung des Kühlkörpers 11 bzw. parallel zu den Schmalseitenwandungen 15 c bzw. 15 d. Bezogen auf einen Querschnitt durch Kühlkörper 11 sind die einzelnen Mediumkanäle 14 in einer Reihe nebeneinander angeordnet.

Jeder (längliche) Mediumkanal 14 ist des Weiteren an (allen) seinen Längsseiten (bezogen auf die Haupterstreckungsrichtung des jeweiligen Mediumkanals 14) durch Mediumkanalwandungen 16 begrenzt. Dies vorliegend jeweils konkret durch zwei Paare von sich jeweils mit Abstand gegenüberliegenden Mediumkanalwandungen 16.

Dabei wird jeder Mediumkanal 14 an zwei gegenüberliegenden (vertikalen bzw. senkrecht zu der oberen und unteren großflächigen Wandung 15 a bzw. 15 b verlaufenden) Längsseiten, nämlich in Querrichtung bzw. senkrecht zur Haupterstreckungsrichtung des Kühlkörpers 11, begrenzt durch ein erstes Paar von jeweils zwei mit Abstand zueinander angeordneten, jeweils zueinander parallel in der Haupterstreckungsrichtung des Kühlkörpers verlaufenden Mediumkanalwandungen 16.

Bei den beiden äußeren Mediumkanälen 14.1 bzw. 14.2 wird dabei eine dieser Mediumkanalwandungen 16 dieses ersten Paares jeweils durch die jeweilige Körperaußenwandung 15 des Kühlkörpers 11 gebildet, vorliegend die Schmalseitenwandung 15 c bzw. die Schmalseitenwandung 15 d.

Jeder (längliche) Mediumkanal 14 ist des Weiteren an seinen anderen beiden Längsseiten durch jeweils ein anderes Paar von Mediumkanalwandungen 16 begrenzt, bei dem die eine Mediumkanalwandung 16 des Paares durch die obere großflächige Wandung 15 a gebildet wird, die andere Mediumkanalwandung 16 des Paares durch die untere großflächige Wandung 15 b.

Jeder Mediumkanal 14 ist vorliegend des Weiteren an seinen beiden Enden bzw. Querseiten offen, nämlich an den Querseiten 17 a und 17 b. Mit anderen Worten findet sich dort keine Wandung, sodass durch die Querseiten 17 a und 17 b Kühlmedium in den Mediumkanal 14 hinein- bzw. aus diesem herausfließen kann.

Was das Anschlussteil 12 betrifft, so weist dieses eine Zulaufkammer 18 mit (oberer) Zulauföffnung 19 auf, über die den Mediumkanälen 14 der ersten Gruppe 14 a von Mediumkanälen 14 Kühlmedium zuführbar ist. Zu diesem Zweck sind die offenen Querseiten 17 a der Mediumkanäle 14 der ersten Gruppe 14 a von Mediumkanälen 14 innerhalb der Zulaufkammer 18 angeordnet, sodass das Kühlmedium unmittelbar aus der Zulaufkammer 18 in/über die offenen Querseiten 17 a in die Mediumkanäle 14 dieser ersten Gruppe 14 a fließen kann.

Das Anschlussteil 12 verfügt des Weiteren über eine von der Zulaufkammer 18 getrennte Ablaufkammer 20 mit Ablauföffnung 21, über die aus den Mediumkanälen 14 der zweiten Gruppe 14 b von Mediumkanälen 14 Kühlmedium abführbar ist. Zu diesem Zweck sind die offenen Querseiten 17 a der Mediumkanäle 14 der zweiten Gruppe 14 b von Mediumkanälen innerhalb der Ablaufkammer 20 angeordnet, sodass das Kühlmedium unmittelbar aus der Ablaufkammer 18 in/über die offenen Querseiten 17 a in die Mediumkanäle 14 dieser zweiten Gruppe 14 b fließen kann.

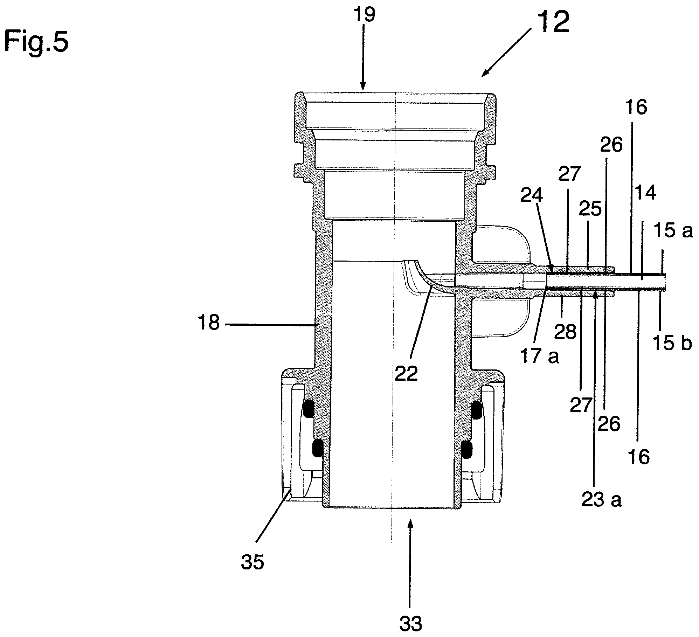

Wie beispielsweise in Fig. 5 zu erkennen ist, verläuft im vorliegenden Fall die Haupterstreckungsrichtung der Mediumkanäle 14 jeweils senkrecht zu der Haupterstreckungsrichtung bzw. Hauptströmungsrichtung der Zulaufkammer 18 bzw. auch der Ablaufkammer 20.

Um dennoch zu ermöglichen, dass Kühlmedium, das über die Zulauföffnung 19 der Zulaufkammer 18 zugeführt wird, in effizienter Weise in die Mediumkanäle 14, nämlich die erste Gruppe 14 a der Mediumkanäle 14 geleitet wird, ist in der Zulaufkammer 18 eine vorliegend einstückig mit dem Anschlussteil 12 verbundene, mindestens bereichsweise winklig zur Hauptströmungsrichtung bzw. Haupterstreckungsrichtung der Zulaufkammer 18 verlaufende (und insbesondere mindestens bereichsweise in Richtung der Zulauföffnung 19 gekrümmte) Fluidleitwandung 22 angeordnet.

Diese ragt vorliegend ausgehend von ihrem Ende, mit dem sie einstückig mit dem Anschlussteil 12 verbunden ist, unter einer Krümmung in Richtung der Zulauföffnung 19 in die Zulaufkammer 18 hinein, und sorgt dafür, dass Kühlmedium, das (in Fig. 5 von oben) auf sie trifft, zu den Mediumkanälen 14 der ersten Gruppe 14 a gelenkt wird.

In ganz analoger Weise (nicht gezeigt) findet sich auch in der Ablaufkammer 20 eine entsprechende Fluidleitwandung, die dort dafür sorgt, dass Kühlmedium, das aus den Mediumkanälen 14 der zweiten Gruppe 14 b in die Ablaufkammer 20 strömt, in Richtung der Ablauföffnung 21 gelenkt wird.

Die Zulauföffnung 19 befindet sich vorliegend im Übrigen an einem Ende der Zulaufkammer 18, und an einem anderen Ende befindet sich eine Anschlussöffnung 33, an die ein Anschlussteil eines (nicht gezeigten) identischen weiteren Kühlbauteils anschließbar ist, insbesondere zur Verbindung der Zulauföffnung des weiteren Kühlbauteils mit der Anschlussöffnung 33.

Die Ablauföffnung 21 befindet sich in analoger Weise an einem Ende der Ablaufkammer 20 und an einem anderen Ende einer Anschlussöffnung 34 der Ablaufkammer 20, an die ein Anschlussteil eines identischen weiteren Kühlbauteils anschließbar ist, insbesondere zur Verbindung der Ablauföffnung 21 des weiteren Kühlbauteils mit der Anschlussöffnung 34.

Das Kühlbauteil 10 bzw. vorliegend das Anschlussteil 12 verfügt des Weiteren noch über Verbindungsmittel 35, insbesondere Rastmittel, zur lösbaren Verbindung des Kühlbauteils mit einem identischen weiteren Kühlbauteil. Dies insbesondere derart, dass nach der Verbindung die Anschlussöffnung 33 der Zulaufkammer 18 mit der Zulauföffnung der Zulaufkammer des weiteren Kühlbauteils unter fluidleitender Verbindung zwischen diesen Öffnungen fluchtet bzw. dass nach der Verbindung die Anschlussöffnung 34 der Ablaufkammer 20 mit der Ablauföffnung der Ablaufkammer des weiteren Kühlbauteils unter fluidleitender Verbindung zwischen diesen Öffnungen fluchtet.

Besonders wichtig ist nun, dass - anders als der Kühlkörper 11 - sowohl das Anschlussteil 12 als auch die Umlenkkappe 13 nicht aus Metall (bzw. ggf. aus einer Metalllegierung) bestehen, sondern aus Kunststoff. Diese Bauteile sind dabei vorliegend jeweils einstückig ausgebildet und als Kunststoff-Spritzgussteil hergestellt, etwa aus Thermoplast.

In besonderer Weise sind der Kühlkörper 11 einerseits und das Anschlussteil 12 bzw. die Umlenkkappe 13 jeweils andererseits miteinander fest und fluiddicht verbunden.

So ist zur Verbindung des Anschlussteils 12 mit dem Kühlkörper 11 ein erster, endständiger Verbindungsbereich 23 a des Kühlkörpers 11 in einen (vorliegend zum dem ersten, im Wesentlichen quaderförmigen Verbindungsbereich 23 a des Kühlkörpers 11 passenden, im Wesentlichen quaderförmigen) Aufnahmeraum 24 einer (hohlquaderförmigen) Aufnahme 25 des Anschlussteils 12 eingebracht und dort mit der Innenseite der Aufnahme 25 fluiddicht verbunden, und zwar mit an der Innenseite angeordneten Verbindungsflächen 27 der Aufnahme 25.

Der metallische Kühlkörpers 11 weist (ebenfalls) Verbindungsflächen auf, nämlich Verbindungsflächen 26 in dem ersten Verbindungsbereich 23 a. Jede dieser (metallischen) Verbindungsflächen 26 des Kühlkörpers 11 weisen dabei jeweils durch physikalische und/oder chemische Nano- oder Mikrostrukturierungsverfahren (wie etwa chemischem Ätzen oder Laserstrahlstrukturieren) in die jeweilige Oberfläche eingebrachte, dreidimensionale Nano- und/oder Mikrostrukturen auf.

Die Verbindungsflächen 26 des Kühlkörpers 11 sind im vorliegenden Fall konkret an den Außenseiten der Körperaußenwandungen 15 angeordnet, und zwar, wie bereits erwähnt, jeweils im ersten Verbindungsbereich 23 a, also in demjenigen Endbereich bzw. Endabschnitt des Kühlkörpers 11, der in den Aufnahmeraum 24 der Aufnahme 25 eingebracht ist und der unmittelbar an die Aufnahme 25 bildende Wandungen 28 angrenzt/anliegt bzw. an die Wandungen 28, die den Aufnahmeraum 24 bilden bzw. begrenzen.

Jede der in der beschriebenen Weise strukturierten Verbindungsflächen 26 des Kühlkörpers 11 liegt dabei jeweils einer zugeordneten Verbindungsfläche 27 der Aufnahme 25 gegenüber ist und mit dieser verbunden, und zwar (unter thermischer Direktfügung) verpresst, wie nachfolgend noch näher ausgeführt werden wird.

In ähnlicher Weise ist im Übrigen auch die Umlenkkappe 13 mit dem Kühlkörper 11 verbunden. Zu diesem Zweck weist der Kühlkörper 11 an seinem anderen Ende, an dem die Umlenkkappe 13 sitzt, einen zweiten Verbindungsbereich 23 b auf, ebenfalls mit mehreren Verbindungsflächen 26 sowie mit jeweils insbesondere durch die genannten physikalischen und/oder chemischen Nano- oder Mikrostrukturierungsverfahren in die jeweilige Oberfläche eingebrachten, dreidimensionalen Nano- und/oder Mikrostrukturen.

Die Umlenkkappe 13 verfügt - ähnlich wie das Anschlussteil 12 - dabei ebenfalls über eine Aufnahme 31 mit einem Aufnahmeraum 30, in den der zweite Verbindungsbereich 23 b des Kühlkörpers 11 eingebracht ist, und ist dort - in analoger Weise wie vorstehend für die Verbindung von Kühlkörper 11 und Aufnahme 25 des Anschlussteils 12 beschrieben - mit der Aufnahme 31 der Umlenkkappe 13 fluiddicht verbunden, indem jede Verbindungsfläche 26 des Kühlkörpers 11 jeweils einer zugeordneten Verbindungsfläche der Aufnahme 31 gegenüberliegt und mit dieser in der beschriebenen Weise verpresst ist.

Die Mediumkanäle 14 verfügen, wie oben bereits angedeutet, im Übrigen auch im Bereich des anderen Endes des Kühlkörpers 11 über offene Querseiten 17 b, wobei diese offenen Querseiten 17 b in einem Umlenkraum 36 der Umlenkkappe 13 angeordnet sind. Die Umlenkkappe 13 ist dabei derart ausgebildet, dass Kühlmedium, das aus den in diesem Bereich des anderen Endes angeordneten offenen Querseiten 17 b der ersten Gruppe 14 a von Mediumkanälen 14 in den Umlenkraum 36 strömt, in dem Umlenkraum 36 zu den offenen Seiten 17 b der Mediumkanäle 14 der zweiten Gruppe 14 b von Mediumkanälen 14 umgelenkt wird, in diese eintritt und in umgekehrter Richtung dann - in der zweiten Gruppe 14 b von Mediumkanälen - durch den Kühlkörper 11 zu dem Anschlussteil 12 zurückströmt.

Die konkrete Herstellung des Kühlbauteils 10 und insbesondere die vorgenannte Verbindung des metallischen Kühlbauteils 10 mit dem aus Kunststoff bestehenden Anschlussteil 12 und mit der aus Kunststoff bestehenden Umlenkkappe 13 erfolgt dabei in besonderer Weise.

Zunächst werden der Kühlkörper 11, das Anschlussteil 12 und die Umlenkkappe 13 separat vorgefertigt.

Anschließend werden die vorgenannten Bauteile 11, 12, 13 miteinander verbunden. Dies wird nachfolgend exemplarisch an der Verbindung des Anschlussteils 12 mit dem Kühlkörper 11 beschrieben. Die Verbindung des Kühlkörpers 11 mit der Umlenkkappe 13 erfolgt in analoger Weise.

Zur Verbindung von Kühlkörper 11 und Anschlussteil 12 werden diese beiden Bauteile zunächst relativ zueinander bewegt. Beispielsweise, indem das Anschlussteil 12 ortsfest festgehalten wird und der Kühlkörper 11 mittels eines geeigneten Förderorgans in Richtung des Anschlussteils 12 bewegt wird. Es versteht sich, dass der Vorgang auch umgekehrt ablaufen kann oder dass beide Bauteile aufeinander zu bewegt werden können.

Im Rahmen der vorgenannten Relativbewegung wird der Kühlkörper 11 dann derart relativ zu dem Anschlussteil 12 bewegt, dass dabei der erste Verbindungsbereich 23 a des Kühlkörpers passgenau so in der Aufnahme 25 bzw. dem Aufnahmeraum 24 platziert wird, dass jede der Verbindungsflächen 26 des ersten Verbindungsbereichs 23 a des Kühlkörpers 11 jeweils einer zugeordneten Verbindungsfläche 27 der Aufnahme 25 des Anschlussteils 12 gegenüberliegt.

Danach, währenddessen und/oder davor werden dann der metallische Kühlkörper 11, zumindest aber die Verbindungsflächen 26 des ersten Verbindungsbereichs 23 a des Kühlkörpers 11, insbesondere mittels einer im Stand der Technik bekannten Induktionsheizung (auch andere Erwärmungstechniken sind natürlich denkbar), auf eine Temperatur erhitzt oder erwärmt, die mindestens der Erweichungstemperatur oder der Schmelztemperatur des Kunststoffs des Anschlussteils 12 bzw. der Aufnahme 25 des Anschlussteils 12 entspricht.

Die Wärme des Kühlkörpers 11 überträgt sich dann, wenn sich der erste Verbindungsbereich 23 a des Kühlkörpers 11 an seiner gewollten Endposition in der Aufnahme 25 befindet, auf das Anschlussteil 12 bzw. dessen Verbindungsflächen 27, was dann zu einem Aufschmelzen der Verbindungsflächen 27 führt.

Beispielsweise durch ein bzw. ggf. jeweils ein Pressorgan, wie etwa eine Pressbacke (nicht gezeigt), das jeweils von außen auf die zu verbindenden Wandungen 28 der Aufnahme 25 drückt, wird dann während und/oder unmittelbar vor und/oder unmittelbar nach dem Aufschmelzen die jeweilige, an der Innenseite der jeweiligen Wandung 28 der Aufnahme 25 angeordnete Verbindungsfläche 27 der Aufnahme 25 gegen die jeweilige (strukturierte) Verbindungsfläche 26 des Kühlkörpers 11 gedrückt bzw. gepresst und so mit dieser fluiddicht verbunden (thermische Direktfügung).

Für eine oder mehrere der zu verbindenden Flächen kann im Übrigen auch vorgesehen sein, dass jeweils ein Paar von sich mit Abstand gegenüberliegenden Verbindungsflächen 26 des Kühlkörpers 11 durch eine alternative Presspassung mit den entsprechenden gegenüberliegenden Wandungen verbunden wird.

Beispielsweise könnten die Verbindungsflächen 26 der Schmalseitenwandungen 15 c, 15 d bzw. die an den Schmalseitenwandungen 15 c, 15 d angeordneten Verbindungsflächen 26 mit den ihnen jeweils gegenüberliegenden Verbindungsflächen 27 der Wandungen 28 der Aufnahme 25 des Anschlussteils 12 verpresst werden, indem im Vorfeld der Verbindung der Abstand der Verbindungsflächen 26 der Schmalseitenwandungen 15 c, 15 d zueinander auf den Abstand der gegenüberliegender Verbindungsflächen 27 des Anschlussteils 12 so abgestimmt ist oder wird, dass sich die Verbindungsflächen 26, wenn sich diese später bereits positionsgenau bzw. in ihrer jeweiligen Endposition in dem Aufnahmeraum 24 des Anschlussteils 12 befinden, durch das (erst in dieser Position erfolgende) Erwärmen der Verbindungsflächen 26 des Kühlkörpers 11 thermisch so ausdehnen, dass sie hierdurch (also ohne ein externes Pressorgan) gegen die jeweils gegenüberliegende Verbindungsfläche 27 der Aufnahme 25 bzw. der Wandung 28 der Aufnahme 25 gedrückt/gepresst werden und dabei die Verbindungsflächen 27 der Aufnahme 25 erwärmen bzw. anschmelzen, sodass (nach dem späteren Erkalten) eine entsprechende Presspassung entsteht.

Es kann beispielsweise auch vorgesehen sein, dass durch ein jeweiliges Pressorgan nur diejenigen Verbindungsflächen 27 der Aufnahme 25 mit den gegenüberliegende Verbindungsfläche 26 des Kühlkörpers 11 verpresst werden, die jeweils der ersten großflächigen Wandung 15 a bzw. der zweiten großflächigen Wandung 15 b des Kühlkörpers 11 gegenüberliegen, und dass die anderen Verbindungsflächen 27 der Aufnahme 25, die jeweils der Verbindungsfläche 26 der jeweiligen Schmalseitenwandung 15 c bzw. 15 d des Kühlkörpers 11 gegenüberliegen, durch die vorstehende Presspassung mit der jeweiligen Verbindungsfläche 26 des Kühlkörpers 11 verbunden werden.

### Bezugszeichenliste:

- 10: Kühlbauteil
- 11: Kühlkörper
- 12: Anschlussteil
- 13: Umlenkkappe
- 14: Mediumkanal
- 14.1: Äußerer Mediumkanal
- 14.2: Äußerer Mediumkanal
- 14 a: erste Gruppe von Mediumkanälen
- 14 b: zweite Gruppe von Mediumkanälen
- 15: Körperaußenwandungen
- 15 a: erste großflächige Wandung
- 15 b: zweite großflächige Wandung
- 15 c: Schmalseitenwandung
- 15 d: Schmalseitenwandung
- 16: Mediumkanalwandung
- 17 a: offene Querseite
- 17 b: offene Querseite
- 18: Zulaufkammer
- 19: Zulauföffnung
- 20: Ablaufkammer
- 21: Ablauföffnung
- 22: Fluidleitwandung
- 23 a: erster Verbindungsbereich Kühlkörper
- 23 b: zweiter Verbindungsbereich Kühlkörper
- 24: Aufnahmeraum Anschlussteil
- 25: Aufnahme Anschlussteil
- 26: Verbindungsflächen Kühlkörper
- 27: Verbindungsflächen Aufnahme Anschlussteil
- 28: Wandungen Aufnahme
- 30: Aufnahmeraum Umlenkkappe
- 31: Aufnahme Umlenkkappe
- 32: Verbindungsflächen Aufnahme Umlenkkappe
- 33: Anschlussöffnung Zulaufkammer
- 34: Anschlussöffnung Ablaufkammer
- 35: Verbindungsmittel
- 36: Umlenkraum Umlenkkappe

## Patentansprüche

1. Kühlbauteil mit einem Kühlkörper (11) aus Metall oder aus einer Metalllegierung, mit dem ein Gegenstand gekühlt werden kann, wobei der Kühlkörper (11) ein oder mehrere, vorzugsweise parallele, insbesondere längliche und/oder geradlinige Mediumkanäle zum Durchfluss von Kühlmedium aufweist, sowie mit einem mit dem Kühlkörper (11) fluiddicht verbundenen Anschlussteil (12), über das dem Kühlkörper (11) das Kühlmedium zuführbar ist und/oder über das von dem Kühlkörper (11) das Kühlmedium abführbar ist, wobei das Anschlussteil (12) aus Kunststoff besteht, bevorzugt ausgebildet ist als Kunststoff-Spritzgussteil, **dadurch gekennzeichnet, dass** zur Verbindung des Anschlussteils (12) mit dem Kühlkörper (11) ein erster Verbindungsbereich des Kühlkörpers (11), der mehrere Verbindungsflächen aufweist mit jeweils durch physikalische und/oder chemische Nano- oder Mikrostrukturierungsverfahren eingebrachten, dreidimensionalen Nano- und/oder Mikrostrukturen, in den Aufnahmeraum einer Aufnahme des Anschlussteils (12) eingebracht ist und dort mit der Aufnahme fluiddicht verbunden ist, indem jede Verbindungsfläche des Kühlkörpers (11) jeweils einer zugeordneten Verbindungsfläche der Aufnahme gegenüberliegt und mit dieser verpresst ist.

2. Kühlbauteil gemäß Anspruch 1, **dadurch gekennzeichnet, dass** der Kühlkörper (11) ein vorzugsweise länglicher, insbesondere extrudierter, bevorzugt quaderförmiger, vorzugsweise einstückiger Profilkörper mit mehreren Außenwandungen bildenden Profilkörperwandungen ist, insbesondere ein Pocketprofilkörper, vorzugsweise mit einer ersten großflächigen, insbesondere ebenen, gebogenen oder gewellten Wandung, mit einer von dieser beabstandeten, zu dieser insbesondere parallel verlaufenden, zweiten großflächigen, insbesondere ebenen, gebogenen oder gewellten Wandung, sowie mit zwei voneinander beabstandeten, die erste und die zweite großflächige Wandung jeweils miteinander verbindenden, insbesondere ebenen, gebogenen oder gewellten Schmalseitenwandungen, wobei bevorzugt die Verbindungsflächen durch (endständige) Bereiche der Außenseiten der Profikörperwandungen gebildet sind und/oder in solchen Bereichen angeordnet sind.

3. Kühlbauteil gemäß einem oder mehreren der vorhergehenden Ansprüche, **dadurch gekennzeichnet, dass** die Aufnahme Aufnahmewandungen aufweist, die den Aufnahmeraum begrenzen, und an deren Innenseiten die Verbindungsflächen der Aufnahme angeordnet sind und/oder deren Innenseiten die Verbindungsflächen bilden, und/oder dass das Anschlussteil (12) eine Zulaufkammer mit Zulauföffnung aufweist, in der Öffnungen oder offene Seiten, insbesondere offene Querseiten, von Mediumkanälen einer ersten Gruppe von Mediumkanälen angeordnet sind, über die den Mediumkanälen dieser ersten Gruppe von Mediumkanälen Kühlmedium zuführbar ist, das über die Zulauföffnung und die Zulaufkammer dem Kühlbauteil zuführbar ist, und/oder dass das Anschlussteil (12) eine insbesondere von der Zulaufkammer getrennte Ablaufkammer mit Ablauföffnung aufweist, in der Öffnungen oder offene Seiten, insbesondere offene Querseiten, von Mediumkanälen einer zweiten Gruppen von Mediumkanälen angeordnet sind, über die Kühlmedium aus dieser zweiten Gruppe von Mediumkanälen in die Ablaufkammer fließen kann, das dann über die Ablauföffnung aus dem Kühlbauteil abführbar ist.

4. Kühlbauteil gemäß einem oder mehreren der vorhergehenden Ansprüche, **dadurch gekennzeichnet, dass** der erste Verbindungsbereich und somit das Anschlussteil (12) an dem einen Ende des Kühlkörpers (11) angeordnet ist, und dass an einem oder dem zweiten, anderen Ende ein zweiter Verbindungsbereich des Kühlkörpers (11) mit mehreren Verbindungsflächen angeordnet ist mit jeweils durch physikalische und/oder chemische Nano- oder Mikrostrukturierungsverfahren eingebrachten, dreidimensionalen Nano- und/oder Mikrostrukturen, der in den Aufnahmeraum einer Aufnahme einer Umlenkkappe (13) aus Kunststoff eingebracht ist oder in den Aufnahmeraum einer Aufnahme eines weiteren Anschlussteils aus Kunststoff, über das dem Kühlkörper (11) das Kühlmedium zuführbar ist und/oder über das von dem Kühlkörper (11) das Kühlmedium abführbar ist, und dort mit der Aufnahme der Umlenkkappe (13) bzw. der Aufnahme des weiteren Anschlussteils fluiddicht verbunden ist, indem jede Verbindungsfläche des Kühlkörpers (11) jeweils einer zugeordneten Verbindungsfläche der Aufnahme gegenüberliegt und mit dieser verpresst ist.

5. Kühlbauteil gemäß Anspruch 4, **dadurch gekennzeichnet, dass** die erste Gruppe und die zweite Gruppe von Mediumkanälen auch im Bereich des anderen Endes des Kühlkörpers (11) offene Seiten oder Öffnungen aufweisen, wobei diese offenen Seiten bzw. Öffnungen in einem Umlenkraum der Umlenkkappe (13) angeordnet sind, und dass die Umlenkkappe (13) derart ausgebildet ist, dass Kühlmedium, das aus den in diesem Bereich des anderen Endes angeordneten offenen Seiten oder Öffnungen der Mediumkanäle der ersten Gruppe von Mediumkanälen in den Umlenkraum strömt oder strömen kann, in dem Umlenkraum zu den offenen Seiten oder Öffnungen der Mediumkanäle der zweiten Gruppe von Mediumkanälen umgelenkt wird und in diese eintreten kann.

6. Kühlbauteil gemäß einem oder mehreren der vorhergehenden Ansprüche, mindestens gemäß Anspruch 3, **dadurch gekennzeichnet, dass** die Hauptströmungsrichtung des Kühlmediums innerhalb der Zulaufkammer winklig, vorzugsweise quer zu den Mediumkanälen verläuft, und dass in die Zulaufkammer eine insbesondere einstückig mit dem Anschlussteil (12), insbesondere der Aufnahme des Anschlussteils (12) verbundene, mindestens bereichsweise insbesondere in Richtung der Zulauföffnung gekrümmte, winklig zur Hauptströmungsrichtung verlaufende Fluidleitwandung hineinragt, insbesondere zur Optimierung der Strömung des Kühlmittels von der Zulauföffnung zu den Mediumkanälen, und/oder dass die Hauptströmungsrichtung des Kühlmediums innerhalb der Ablaufkammer (ggf. jeweils) winklig, vorzugsweise quer zu den Mediumkanälen verläuft, und dass in die Ablaufkammer eine insbesondere einstückig mit dem Anschlussteil (12), insbesondere der Aufnahme des Anschlussteils (12) verbundene, mindestens bereichsweise insbesondere in Richtung der Ablauföffnung gekrümmte, winklig zur Hauptströmungsrichtung verlaufende Fluidleitwandung hineinragt, insbesondere zur Optimierung der Strömung des Kühlmittels aus den Mediumkanälen zu der Ablauföffnung.

7. Kühlbauteil gemäß einem oder mehreren der vorhergehenden Ansprüche, mindestens gemäß Anspruch 3, **dadurch gekennzeichnet, dass** sich die Zulauföffnung an einem Ende der Zulaufkammer befindet und an einem anderen Ende eine Anschlussöffnung, an die ein Anschlussteil (12) eines identischen weiteren Kühlbauteils anschließbar ist, insbesondere zur Verbindung der Zulauföffnung des weiteren Kühlbauteils mit der Anschlussöffnung, und/oder dass sich die Ablauföffnung an einem Ende der Ablaufkammer befindet und an einem anderen Ende eine Anschlussöffnung, an die ein Anschlussteil (12) eines identischen weiteren Kühlbauteils anschließbar ist, insbesondere zur Verbindung der Ablauföffnung des weiteren Kühlbauteils mit der Anschlussöffnung, und/oder dass sich die Zulauföffnung und/oder die Anschlussöffnung in einer Ebene quer zur Hauptströmungsrichtung innerhalb der Zulaufkammer bzw. quer zur Haupterstreckungsrichtung der Zulaufkammer erstreckt, und/oder dass sich die Ablauföffnung und/oder die Anschlussöffnung in einer Ebene quer zur Hauptströmungsrichtung innerhalb der Ablaufkammer bzw. quer zur Haupterstreckungsrichtung der Ablaufkammer erstreckt.

8. Kühlbauteil gemäß einem oder mehreren der vorhergehenden Ansprüche, **dadurch gekennzeichnet, dass** das Kühlbauteil Verbindungsmittel, insbesondere Rastmittel aufweist zur lösbaren Verbindung des Kühlbauteils mit einem identischen weiteren Kühlbauteil, insbesondere derart, dass nach der Verbindung die Anschlussöffnung der Zulaufkammer mit der Zulauföffnung der Zulaufkammer des weiteren Kühlbauteils unter fluidleitender Verbindung zwischen den Öffnungen fluchtet, und/oder dass nach der Verbindung die Anschlussöffnung der Ablaufkammer mit der Ablauföffnung der Ablaufkammer des weiteren Kühlbauteils unter fluidleitender Verbindung zwischen den Öffnungen fluchtet.

9. Kühlbauteil gemäß einem oder mehreren der vorhergehenden Ansprüche, **dadurch gekennzeichnet, dass** jeder (längliche) Mediumkanal an (allen) seinen Längsseiten durch Mediumkanalwandungen begrenzt ist - insbesondere durch zwei Paare von sich jeweils mit Abstand gegenüberliegenden Mediumkanalwandungen, wobei die Mediumkanalwandungen eines der Paare jeweils durch die erste bzw. die zweite großflächige Wandung des Kühlbauteils gebildet wird - und/oder an seinen Querseiten offen ist, wobei vorzugsweise die offenen Querseiten die offenen Seiten bilden, die in der Ablaufkammer bzw. der Zulaufkammer bzw. dem Umlenkraum angeordnet sind.

10. Kühlbauteil gemäß einem oder mehreren der vorhergehenden Ansprüche, mindestens gemäß Anspruch 4, **dadurch gekennzeichnet, dass** das weitere Anschlussteil ein, mehrere oder sämtliche Merkmale des ersten Anschlussteils aufweist.

## Claims

1. Cooling component having a cooling body (11) made of metal or a metal alloy, with which an object may be cooled, wherein the cooling body (11) has one or more, preferably parallel, in particular elongated and/or linear medium channels for the throughflow of cooling medium, and having a connection part (12), which is connected to the cooling body in a fluid-tight manner and via which the cooling medium can be supplied to the cooling body (11) and/or via which the cooling medium can be discharged from the cooling body (11), wherein the connection part (12) is made from plastic, preferably formed as a plastic injection molded part, **characterized in that** a first, connecting region of the cooling body (11), which has a plurality of connecting faces, each with three-dimensional nanostructures and/or microstructures introduced by physical and/or chemical nanostructuring or microstructuring methods, is incorporated in the receiving space of a receptacle of the connection part (12) to connect the connection part (12) to the cooling body (11), and is connected there to the receptacle in a fluid-tight manner **in that** each connecting face of the cooling body (11) is opposite a respectively associated connecting face of the receptacle and is pressed together with this.

2. Cooling component according to claim 1, **characterized in that** the cooling body (11) is a preferably elongated, in particular extruded, preferably cuboidal, profile body, preferably realized in one piece, having a plurality of profile body walls which form outer walls, in particular a pocket profile body, preferably with a first large-area-, in particular planar, bent or corrugated wall, with a second large-area, in particular planar, bent or corrugated wall, which is spaced therefrom and extends, in particular, parallel thereto, and with two mutually spaced, in particular planar, bent or corrugated, narrow side walls connecting the first and the second large-area wall to one another in each case, wherein preferably the connecting faces are formed by (terminal) regions of the outer sides of the profile body walls and/or are arranged in such regions.

3. Cooling component according to one or more of the preceding claims, **characterized in that** the receptacle has receptacle walls, which delimit the receiving space, and on the inner sides of which the connecting faces of the receptacle are arranged and/or whereof the inner sides form the connecting faces, and/or that the connection part (12) has an inlet chamber having an inlet opening in which openings or open sides, in particular open transverse sides, of medium channels of a first group of medium channels are arranged, via which cooling medium can be supplied to the medium channels of this first group of medium channels, which cooling medium can be supplied to the cooling component via the inlet opening and the inlet chamber, and/or that the connection part (12) has an outlet chamber which is, in particular, separate from the inlet chamber and has an outlet opening in which openings or opens sides, in particular open transverse sides, of medium channels of a second group of medium channels are arranged via which cooling medium may flow out of this second group of medium channels and into the outlet chamber and can then be discharged from the cooling component via the outlet opening.

4. Cooling component according to one or more of the preceding claims, **characterized in that** the first connecting region, and therefore the connection part (12), is arranged at one end of the cooling body (11), and that at a or a second, other end a connecting region of the cooling body (11) with a plurality of connecting faces, each with three-dimensional nanostructures and/or microstructures introduced, by physical and/or chemical nanostructuring or microstructuring methods, is arranged, which second connecting region is inserted in the receiving space of a receptacle of a deflection cap (13) made of plastic or in the receiving space of a receptacle of a further connection part made of plastic, via which the cooling medium can be supplied to the cooling body (11) and/or via which the cooling medium can be discharged from the cooling body (11), and is connected there to the receptacle of the deflection cap (13) or to the receptacle of the further connection part in a fluid-tight manner in that each connecting face of the cooling body (11) is opposite a respectively associated connecting face of the receptacle and is pressed together with this.

5. Cooling component according to claim 4, **characterized in that** the first group and the second group of medium channels also have open sides or openings in the region of the other end of the cooling body (11), wherein these open sides or openings are arranged in a deflection space of the deflection cap (13), and that the deflection cap (13) is designed in such a way that, in the deflection space, cooling medium which flows, or may flow, into the deflection space from the open sides or openings arranged in this region of the other end of the medium channels of the first group of medium channels is deflected to the open sides or openings of the medium channels of the second group of medium channels and may enter these medium channels.

6. Cooling component according to one or more of the preceding claims, at least according to claim 3, **characterized in that** the main flow direction of the cooling medium within the inlet chamber extends at an angle, preferably transversely to the medium channels, and that, in particular to optimize the flow of coolant from the inlet opening to the medium channels, a fluid-conducting wall projects into the inlet chamber, which fluid-conducting wall is, in particular, connected to the connection part (12) in one piece, in particular to the receptacle of the connection part (12), at an angle to the main flow direction and is, in particular, curved in the direction of the inlet opening, at least in some regions, and/or that, in particular to optimize the flow of the coolant from the medium channels into the outlet opening, the main flow direction of the cooling medium within the outlet chamber extends (possibly in each case) at an angle, preferably transversely to the medium channels, and that a fluid-conducting wall projects into the outlet chamber, which fluid-conducting wall is, in particular, connected to the connection part (12) in one piece, in particular to the receptacle of the connection part (12), at an angle to the main flow direction and is, in particular, curved in the direction of the outlet opening, at least in some regions.

7. Cooling component according to one or more of the preceding claims, at least according to claim 3, **characterized in that** the inlet opening is located at one end of the inlet chamber and a connection opening, to which a connection part (12) of an identical further cooling component can be connected, is located at another end, in particular to connect the inlet opening of the further cooling component to the connection opening, and/or that the outlet opening is located at one end of the outlet chamber and a connection opening, to which a connection part (12) of an identical further cooling component can be connected, is located at another end, in particular to connect the outlet opening of the further cooling component to the connection opening, and/or that the inlet opening and/or the connection opening extends in a plane transversely to the main flow direction within the inlet chamber or transversely to the main direction of extent of the inlet chamber, and/or that the outlet opening and/or the connection opening extends in a plane transversely to the main flow direction within the outlet chamber or transversely to the main direction of extent of the outlet chamber.

8. Cooling component according to one or more of the preceding claims, **characterized in that** the cooling component has connecting means, in particular latching means, for releasably connecting the cooling component to an identical further cooling component, in particular in such a way that, after connection, the connection opening of the inlet chamber is flush with the inlet opening of the inlet chamber of the further cooling component with a fluid-conducting connection between the openings, and/or that, after connection, the connection opening of the outlet chamber is flush with the outlet opening of the outlet chamber of the further cooling component with a fluid-conducting connection between the openings.

9. Cooling component according to one or more of the preceding claims, **characterized in that** each (elongated) medium channel is delimited at (all of) its longitudinal sides by medium channel walls - in particular by two pairs of medium channel walls which are opposite one another at a spacing in each case, wherein each of the medium channel walls of one of the pairs is formed by the first or the second large-area wall of the cooling component - and/or is open at its transverse sides, wherein the open transverse sides preferably form the open sides which are arranged in the outlet chamber or in the inlet chamber or in the deflection space.

10. Cooling component according to one or more of the preceding claims, at least according to claim 4, **characterized in that** the further connection part has one, more or all of the features of the first connection part.

## Revendications

1. Composant de refroidissement comprenant un dissipateur thermique (11) en métal ou en alliage métallique, permettant de refroidir un objet, le dissipateur thermique (11) comportant un ou plusieurs canaux de fluide, de préférence parallèles, notamment allongés et/ou rectilignes, destinés au passage d'un fluide de refroidissement, ainsi qu'un élément de raccordement (12) relié de manière étanche aux fluides au dissipateur thermique (11) par l'intermédiaire de laquelle le fluide de refroidissement peut être amené au dissipateur thermique (11) et/ou par l'intermédiaire de laquelle le fluide de refroidissement peut être évacué du dissipateur thermique (11), l'élément de raccordement (12) étant en matière plastique, de préférence réalisé sous la forme d'une pièce moulée par injection en matière plastique, **caractérisé en ce que**, pour relier l'élément de raccordement (12) au dissipateur thermique (11), une première zone de liaison du dissipateur thermique (11), qui comporte plusieurs surfaces de liaison sur lesquelles sont respectivement apportées, par des procédés de nanostructuration ou de microstructuration physiques et/ou chimiques, des nano- et/ou microstructures tridimensionnelles, est introduite dans l'espace de logement d'un logement de l'élément de raccordement (12) et y est reliée de manière étanche aux fluides, chaque surface de raccordement du dissipateur thermique (11) faisant face à une surface de raccordement associée du logement et étant pressée contre celle-ci.

2. Composant de refroidissement selon la revendication 1, **caractérisé en ce que** le dissipateur thermique (11) est un corps profilé de préférence allongé, en particulier extrudé, de préférence parallélépipédique, de préférence monobloc, comportant plusieurs parois formant des parois de corps profilé, en particulier un corps profilé à poches, de préférence avec une première paroi de grande surface, en particulier plane, courbée ou ondulée, avec une deuxième paroi de grande surface, notamment plane, courbée ou ondulée, espacée de celle-ci et s'étendant notamment parallèlement à celle-ci, ainsi qu'avec deux parois latérales étroites, notamment planes, courbées ou ondulées, espacées l'une de l'autre, reliant respectivement entre elles la première et la deuxième paroi de grande surface, les surfaces de liaison étant de préférence formées par des zones (d'extrémité) des faces extérieures des parois du corps profilé et/ou sont disposées dans de telles zones.

3. Composant de refroidissement selon l'une ou plusieurs des revendications précédentes, **caractérisé en ce que** le logement comporte des parois de logement qui délimitent l'espace de logement, et sur les faces intérieures desquelles sont disposées les surfaces de liaison du logement et/ou dont les faces intérieures forment les surfaces de liaison, et/ou **en ce que** l'élément de raccordement (12) comporte une chambre d'alimentation avec une ouverture d'alimentation, dans laquelle sont disposées des ouvertures ou des côtés ouverts, en particulier des côtés transversaux ouverts, de canaux de fluide d'un premier groupe de canaux de fluide, par l'intermédiaire desquels un fluide de refroidissement peut être acheminé vers les canaux de fluide de ce premier groupe de canaux de fluide, lequel fluide de refroidissement peut être acheminé vers le composant de refroidissement via l'ouverture d'alimentation et la chambre d'alimentation, et/ou que l'élément de raccordement (12) comporte une chambre d'évacuation, séparée notamment de la chambre d'alimentation, avec une ouverture d'évacuation, dans laquelle sont disposées des ouvertures ou des côtés ouverts, en particulier des côtés transversaux ouverts, par rapport à des canaux de fluide d'un deuxième groupe de canaux de fluide, par l'intermédiaire desquels le fluide de refroidissement provenant de ce deuxième groupe de canaux de fluide peut s'écouler dans la chambre d'évacuation, d'où il peut ensuite être évacué hors de l'élément de refroidissement par l'ouverture d'évacuation.

4. Composant de refroidissement selon l'une ou plusieurs des revendications précédentes, **caractérisé en ce que** la première zone de raccordement et donc l'élément de raccordement (12) est disposée à l'une des extrémités du corps de refroidissement (11), et **en ce qu'**à l'autre extrémité, ou à la deuxième extrémité, une deuxième zone de raccordement du corps de refroidissement (11) est disposée avec plusieurs surfaces de raccordement comportant chacune des nanostructures et/ou microstructures tridimensionnelles réalisées par des procédés de nanostructuration et/ou de microstructuration physiques et/ou chimiques, laquelle est insérée dans l'espace de réception d'un logement d'un capuchon de déviation (13) en plastique ou dans l'espace de réception d'un logement d'une autre pièce de raccordement en plastique, par l'intermédiaire de laquelle le fluide de refroidissement peut être amené au et/ou par lequel le fluide de refroidissement peut être évacué du dissipateur thermique (11), et y est relié de manière étanche aux fluides au logement du capuchon de déviation (13) ou au logement de l'autre élément de raccordement, chaque surface de raccordement du dissipateur thermique (11) faisant face à une surface de raccordement correspondante du logement et étant pressée contre celle-ci.

5. Composant de refroidissement selon la revendication 4, **caractérisé en ce que** le premier groupe et le deuxième groupe de canaux de fluide présentent également, dans la zone de l'autre extrémité du dissipateur thermique (11), des côtés ouverts ou des ouvertures, ces côtés ouverts ou ouvertures étant disposés dans une chambre de déviation du capuchon de déviation (13), et **en ce que** le capuchon de déviation (13) est conçu de telle sorte que le fluide de refroidissement qui s'écoule ou peut s'écouler depuis les côtés ouverts ou les ouvertures des canaux de fluide du premier groupe de canaux de fluide, disposés dans cette zone de l'autre extrémité, vers l'espace de déviation, soit dévié dans l'espace de déviation vers les côtés ouverts ou les ouvertures des canaux de fluide du deuxième groupe de canaux de fluide et puisse y pénétrer.

6. Composant de refroidissement selon l'une ou plusieurs des revendications précédentes, au moins selon la revendication 3, **caractérisé en ce que** la direction d'écoulement principale du fluide de refroidissement à l'intérieur de la chambre d'admission s'étend de manière angulaire, de préférence transversalement par rapport aux canaux de fluide, et **en ce que** dans la chambre d'admission s'étend une paroi de guidage de fluide, notamment d'un seul tenant avec l'élément de raccordement (12), en particulier au logement de l'élément de raccordement (12), courbée au moins par endroits, notamment en direction de l'ouverture d'entrée, et s'étendant angulairement par rapport à la direction d'écoulement principale, en particulier pour optimiser l'écoulement du fluide de refroidissement depuis l'ouverture d'entrée vers les canaux de fluide, et/ou **en ce que** la direction principale d'écoulement du fluide de refroidissement à l'intérieur de la chambre de sortie s'étend (le cas échéant) sous un angle, de préférence transversalement par rapport aux canaux de fluide, et qu'une paroi de guidage de fluide, reliée notamment d'un seul tenant à l'élément de raccordement (12), en particulier au logement de l'élément de raccordement (12), courbée au moins par endroits, notamment en direction de l'orifice de sortie, et s'étendant angulairement par rapport à la direction principale d'écoulement, en particulier pour optimiser l'écoulement du fluide de refroidissement depuis les canaux de fluide vers l'orifice de sortie.

7. Composant de refroidissement selon l'une ou plusieurs des revendications précédentes, au moins selon la revendication 3, **caractérisé en ce que** l'ouverture d'entrée se trouve à une extrémité de la chambre d'entrée et qu'à une autre extrémité, une ouverture de raccordement à laquelle peut être raccordée un élément de raccordement (12) d'un autre composant de refroidissement identique, notamment pour relier l'ouverture d'entrée de l'autre composant de refroidissement à l'ouverture de raccordement, et/ou **en ce que** l'orifice de sortie se trouve à une extrémité de la chambre de sortie et qu'à une autre extrémité se trouve un orifice de raccordement auquel peut être raccordée un élément de raccordement (12) d'un autre élément de refroidissement identique, notamment pour relier l'orifice de sortie de cet autre élément de refroidissement à l'orifice de raccordement, et/ou que l'orifice d'entrée et/ou l'orifice de raccordement s'étendent dans un plan transversal à la direction principale d'écoulement à l'intérieur de la chambre d'entrée ou transversal à la direction principale d'extension de la chambre d'entrée, et/ou que l'orifice de sortie et/ou l'orifice de raccordement s'étendent dans un plan transversal à la direction principale d'écoulement à l'intérieur de la chambre de sortie ou transversal à la direction principale d'extension de la chambre de sortie.

8. Composant de refroidissement selon l'une ou plusieurs des revendications précédentes, **caractérisé en ce que** le composant de refroidissement comporte des moyens de liaison, en particulier des moyens d'encliquetage, pour la liaison amovible du composant de refroidissement avec un autre composant de refroidissement identique, en particulier de telle sorte qu'après l'assemblage, l'ouverture de raccordement de la chambre d'admission soit alignée avec l'ouverture d'admission de la chambre d'admission de l'autre composant de refroidissement, avec une communication fluidique entre les ouvertures, et/ou que, après l'assemblage, l'ouverture de raccordement de la chambre d'évacuation soit alignée avec l'ouverture d'évacuation de la chambre d'évacuation de l'autre composant de refroidissement, avec une communication fluidique entre les ouvertures.

9. Composant de refroidissement selon l'une ou plusieurs des revendications précédentes, **caractérisé en ce que** chaque canal de fluide (allongé) est délimité sur (tous) ses côtés longitudinaux par des parois de canal de fluide - en particulier par deux paires de parois de canal de fluide situées à distance l'une de l'autre, les parois de canal de fluide de l'une des paires étant formées respectivement par la première et la deuxième paroi de grande surface de l'élément de refroidissement - et/ou est ouvert sur ses côtés transversaux, les côtés transversaux ouverts formant de préférence les côtés ouverts qui sont disposés dans la chambre de sortie, la chambre d'entrée ou l'espace de déviation.

10. Composant de refroidissement selon l'une ou plusieurs des revendications précédentes, au moins selon la revendication 4, **caractérisé en ce que** l'autre élément de raccordement présente une, plusieurs ou toutes les caractéristiques du premier élément de raccordement.
